# EUROPEAN PATENT SPECIFICATION

(11) **EP 2 260 563 B1**
(45) Date of publication and mention of the grant of the patent: **26.10.2011**
(21) Application number: 09717988.1
(22) Date of filing: 06.03.2009
(51) Int. Cl.: H02J 9/00

(54) **ELECTRICAL APPLIANCE MONITORING SYSTEMS**
ÜBERWACHUNGSSYSTEM FÜR ELEKTROGERÄTE
SYSTÈMES DE SURVEILLANCE D APPAREILS ÉLECTRIQUES

(30) Priority: 07.03.2008 GB 0804275
(43) Date of publication of application: 15.12.2010
(73) Proprietor: AlertMe.com Ltd., Cambridgeshire CB2 1UJ (GB)
(72) Inventor: BEART, Pilgrim Giles William, Cambridge Cambridgeshire CB5 8DZ (GB); JAMES, Laura B., Cambridgeshire CB24 9PN (GB); PHILLIPS, Amyas Edward Wykes, Cambridge CB2 1SB (GB)
(74) Representative: Martin, Philip John
(86) International application number: PCT/GB2009/050226
(87) International publication number: WO 2009/109787

(56) References cited:
- WO-A-2006/025041
- DE-A1- 10 026 457
- GB-A- 2 439 763
- US-A1- 2002 000 092
- US-A1- 2006 238 293
- US-A1- 2007 262 646

## Description

### FIELD OF THE INVENTION

This invention relates to apparatus and computer program code for monitoring electrical appliances using plug-through devices.

### BACKGROUND TO THE INVENTION

A plug-through device is one that plugs into a standard electrical power outlet and into which an electrical appliance is itself plugged, so that the plug-through device is interposed between the electrical outlet and the appliance. A plug-through device may provide its user with many functions, but its position is especially well suited to the monitoring and regulation of electrical power to the appliance. Plug-through devices are commonly used for the measurement and logging of appliances' energy usage, for warning of power disruptions, e.g. to refrigerators, for protection of appliances from abnormalities in the electricity supply. Plug-through devices which are able to switch on or off the electricity supply to the appliance are known as plug-through controllers. Plug-through controllers are commonly used with timers to automatically turn on lamps at night, e.g. to give an unoccupied house the appearance of occupation, and with communication means for remote control, e.g. of lamps and of devices with high standby current such as televisions.

Security systems are concerned with the safety of persons and property. They typically include a variety of specialised sensors, each adapted to detection of a particular security condition at a particular location, e.g. unauthorised intrusion, fire, flood. The detection of unauthorised intrusion requires such systems to be aware of whether persons are present, and whether or not they are expected to be present.

Background prior art can be found in: GB2,439,763A; US2003/0016129; GB2,419,210A; US2002/003688; US5,984,513; DE3,103,503A; on the website www.myhome247.co.uk; and on the website www.smarthomeusa.com.

British patent publication GB 2439763, of Croft and Reynolds, published 2008-01-09 , relates to an intelligent power saving device for electrical devices such as televisions which have a standby mode. The power saving device comprises an AC power measuring circuit to derive the state of the connected device by measuring its power consumption, a switch to control output power, a motion or presence detector and either controlling logic or a microcontroller. The invention disconnects the mains power from the electrical device while there is no person present, but only if the device is in its standby mode.

US patent application publication US2007262646 A1, of Youhan Electronics Co. Ltd., published 2007-11-15, discloses a multifunctional multi-tap (concent) of intercepting a stand-by electric power and a control method employing the same which prevent big fire generated by leakage current by performing an interlocking control and a single-acting control (separate control) in accordance with subordination of respective appliances using a illumination sensor or a body-detecting sensor.

US patent application publication US2002000092 (A1), of Robertshaw Controls Company, published 2002-01-03, discloses unit attached to a refrigeration appliance, such as a freezer, or refrigerator, to alert the user of a sensed condition within the appliance that food spoilage may occur. The unit can monitor temperature within the compartment and determine how long until food spoilage occurs. The unit also can alert a user, monitoring service, or call a repairperson. The unit may be retrofit into existing appliances.

International patent application publication WO2006025041 (A2), of Ryan, Edmonds and Curran, published 2006-03-09, discloses that control apparatus for selectively applying a mains AC electrical supply to an electrical appliance in response to a remote signal received via a cellular telecommunications network comprises a housing within which an electrical socket for providing power to the appliance is integrally formed.

German patent application publication DE10026457 (A1), of Mayer Guenther, published 2001-11-29, discloses that a monitoring device is activated automatically, when a device to be controlled is switched ON. A time setting key sets up the time factor corresponding to the device and the time is displayed in a clock display. A horn is activated to output an audio signal, when a presence detection key detects that the device has not been handled for a specific time period.

### SUMMARY OF THE INVENTION

According to a first aspect of the present invention, there is provided an intruder alarm system including a monitoring system, as defined in appended independent claim 1.

Preferred embodiments are defined in the appended dependent claims.

### BRIEF DESCRIPTION OF THE DRAWINGS

These and other aspects of the invention will now be further described, by way of example only with reference to the accompanying figures in which:
Figure 1 shows a schematic block diagram of a plug-through controller according to an embodiment of an aspect of the invention;
Figure 2 shows an intruder alarm system incorporating presence-detection and a plug-through controller, according to an embodiment of the invention;
Figure 3 shows, schematically, elements of an electrical appliance monitoring system according to an embodiment of the invention;
Figure 4 illustrates using an exploded diagram an example configuration of a plug-through controller, associated mains electricity outlet and controlled appliance;
Figure 5 illustrates an intruder alarm system incorporating plug-through controllers;
Figure 6 shows a security system state machine with inferred presence and absence indications;
Figure 7 shows state machine for a presence-aware plug-through controller, integrated with a security system as in figure 6; and
Figure 8 shows schematically the functional modules of the security system controller of Figure 2.

### DETAILED DESCRIPTION OF PREFERRED EMBODIMENTS

We will describe the combination of plug-through controllers with automatic awareness of whether anybody is present at the controller's location, in order to enhance safety and energy efficiency. In embodiments the controller automatically turns off hazardous and high standby-current devices when no-one is present.

A system for monitoring one or more mains-powered electrical appliances comprises: at least one plug-through device for monitoring a power state of an electrical appliance; at least one occupancy detection device to detect human presence in a location of said electrical appliance; and a system controller coupled to said plug-through device and to said occupancy detection device and configured to provide a monitoring signal responsive to a determined combination of a said power state of said electrical appliance and absence of human presence in said location of said electrical appliance.

According to the invention the plug-through device comprises a plug-through controller and includes a switch to switch off mains power to the appliance. The system controller then employs the monitoring signal to control the plug-through controller. It will be appreciated that the monitoring signal may be internal and/or external to the system. Thus the monitoring signal may also be employed to alert a user to the electrical appliance being left in an on state. Still further, optionally, the power state of the appliance may be monitored to detect when the appliance is in a standby power state, for example by detecting a reduction of power consumption from a normal, in-use level to a relatively constant but non-zero lower level. In this way one or more electrical appliances may automatically be taken from a standby to a fully off state, for example when a house or other building is unoccupied.

The skilled person will appreciate that the occupancy detection device, in an installed system, need not detect human presence specifically at the location of the electrical appliance. For example, the presence of a person anywhere in a house or other building in which the electrical appliance is located could be detected say by means of an entry/exit switch. In preferred embodiments, however, a sensor is used to monitor at least a room in which the electrical appliance is located. Conveniently a passive infra-red (PIR) sensor may be employed although other types of sensor may also be used. Again it will be appreciated that the sensor need not be pointing directly at the electrical appliance in order to determine whether or not a person is present in the same room as the appliance.

According to the invention the system is part of an intruder alarm. Functions of the intruder alarm system already present to determine human occupancy may be exploited for use by the presence-aware plug-through controller to infer human presence in a location (room or house or other building) of the electrical appliance. For example if the intruder alarm system is in an armed state (or has an armed zone) then it can be inferred that there is no person present (or present in the zone). The alarm system may be manually or automatically armed. Similarly, if the intruder alarm system is not in an alarmed state it may also be inferred that no person is present. Thus human presence may also be inferred from an alarm state of the system-alarmed or not alarmed.

In a complementary manner, the electrical appliance monitoring system may be employed to enhance the functionality of the intruder alarm. Thus in embodiments the monitored power state of an appliance, such as a lamp, may be employed to detect an intruder.

According to the invention, the intruder alarm system alerts the user if the user attempts to arm the intruder alarm system when the monitoring signal indicates that an appliance has been left on. Optionally, one or more additional rules may be built into the system, for example, only to alert the user if more than a threshold current or power is being drawn (for example, to selectively alert if a device with a heating element has been left on) and/or to introduce a time delay so that an appliance may be left on for a certain, for example user selected, period of time without an alert being generated. This may be employed, for example, where it is desirable to leave a cooking device on a timer for a period.

The intruder alarm system incorporates an energy monitoring system, the energy H monitoring system including a plurality of energy monitor-controller modules each configured to monitor the power drawn by an electrical appliance and to control the electrical appliance, wherein the intruder alarm system is configured to infer human presence from an armed/disarmed state of the system and automatically to identify when one or more user designated devices is left operating unattended and in response to perform one or both of alerting a user and automatically turning off said identified devices.

In embodiments the user may be provided with a web-based or other remote interface to enable the user to designate particular devices which should be off when the monitored premises are unoccupied, as determined by the armed/unarmed condition of the intruder alarm system. These may comprise hazardous devices, for example a device which is designed to provide a heat source, such as an electric fire, cooker or iron, and/or high-standby power devices, for example, devices requiring a standby power of greater than 1 watt.

In general, embodiments of the above described systems are configured to apply one or more rules to identify the determined combination of power state and absence of human presence which gives rise to the monitoring signal. Multiple different combinations may be employed to define complex combinations of power state and human presence if desired. In embodiments such rules may include one or more of: a rule dependent on a power state of the appliance being greater or less than a threshold, a rule dependent on an elapsed time since human presence was last detected in the location, a rule dependent on a light level detected by the system (for day/night selection), and a time-of-day/week/month/year dependent rule. In embodiments a rule, may comprise a rule to inhibit a user alert or automatic switching off of the appliance, as previously indicated.

In some preferred embodiments the above described systems include an interface to a mobile communications network to enable the system to provide an alert using the network, for example by means of an SMS (short message service) text communication.

In some preferred implementations the system is implemented using a client-server approach. Thus, an Internet-connected server is employed to provide a web interface for configuring the system. For example in embodiments this enables a user to control who is alerted and how and to set one or more rules or conditions for an alert. In embodiments the complexity of the rules may be masked by simply allowing a user to select a typical use case which would then in turn invoke a set of more complex rules, for example based upon when the system is armed, when motion is been detected, and by what sensor(s), the power consumption detected by the plug-through device and so forth. Once the system configuration has been entered the server then sends a configuration data file to a hub computer system at the premises at which the appliance(s) are to be monitored. This hub computer system preferably has a broadband connection to the server and preferably also a backup communications system, for example GPRS (General Packet Radio Service). In preferred embodiments the hub is in wireless communication with one or more sensors and one or more plug-through devices and, optionally, other devices such as a wireless keyfob for arming/disarming the system, a wireless-controlled lamp, optionally a variable colour to provide visual user alerts, and one or more smoke detectors. Preferably the hub also includes a log in module to collect data from the sensor(s) and plug-through device(s) to provide a historical data log; in embodiments this is sent to the server. The hub may also include a module to provide speech output for spoken user alerts.

In other implementations of the system, the entire system may be physically located in the plug-through device. Thus, in embodiments there is provided a plug-through device including at least one occupancy detection device such as a PIR sensor, and a system controller, in particular to control mains power to the appliance in response to detection of the absence of human presence. Such a device may therefore operate as a stand-alone system or "intelligent" presence-aware plug through controller.

In a related aspect there is therefore provided a plug-through controller for use with a system as described above, the plug-through controller including a power state monitoring system to monitor a power state of an electrical appliance connected to the plug-through controller, a wireless communications module coupled to said power state monitoring system for communicating said power state to said system controller, and a controllable switch coupled to said wireless communications module for switching off power to said appliance on response to a command signal from said system controller.

Computer program code may implement a system controller as described above. The code may be provided on a carrier such as a disk, for example a CD- or DVD-ROM, or in programmed memory for example as Firmware. Code (and/or data) to implement embodiments of the invention may comprise source, object or executable code in a conventional programming language (interpreted or compiled) such as C. As the skilled person will appreciate such code and/or data may be distributed between a plurality of coupled components in communication with one another.

Awareness of whether anybody is present may be provided by means of a separate or integrated presence detector, such as a passive infra-red (PIR) motion detector, a microwave Doppler radar, a pressure sensor, automatic detection of people within images formed by camera apparatus, or any of a number of other sensor types.

Awareness of whether anybody is present may also be provided by communication with the intruder alarm system. Users can set the intruder alarm system to 'armed' and 'disarmed' states. In the armed state, any intrusion detected will cause the sounding of an alarm, and it may be inferred that nobody is expected to be present. In the disarmed state the system becomes inactive and it may be inferred that people are now expected to be present. If the system also allows 'part armed' states, the expectation of whether people are present or not may be inferred from whether the location of the plug-through controller lies within an 'armed' zone or not. Some systems may also have explicit presence detection and reporting functions, e.g. for managing lighting.

The computer logic for monitoring and commanding the plug-through controller, the presence detector, the intruder alarm system, and the plug-through controller itself may be co-located or separate. Communication means allow the computer logic to find out from the presence detector and/or the intruder alarm system whether anybody is present or not. Communication means also allow the computer logic to command the plug-through controller to turn on or off power to the appliance.

One possible communication means is a wired connection. This may be a simple presence/no presence or on/off signal line. Alternatively it may be a field bus such as LonWorks ® or KNX ®, or it may utilise pre-existing mains wiring using power-line communications technology such as HomePlug ®. Wireless communication means are also possible, using proprietary RF modulation schemes and protocols, or standards such as IEEE 802.15.4 (WiFi), Bluetooth ®, or ZigBee ®.

The computer logic for monitoring and commanding the plug-through controller may base its decisions on a variety of inputs in addition to whether or not anyone is present. For instance, it may use time of day, elapsed time since any person was last present, or the type of appliance being controlled.

The intrusion alarm system may gain the ability to detect intrusion by observation of unexpected electricity usage, e.g. when an intruder turns on a lamp.

An embodiment of the invention will now be further described by way of the specific example of a security system including one or more presence-aware plug-through controllers, with reference to the accompanying drawings.

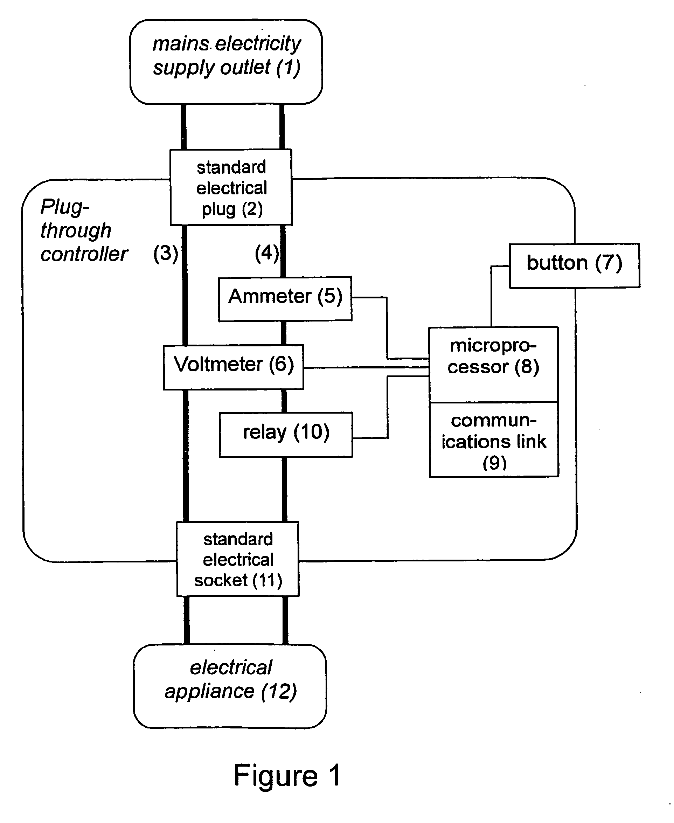

Figure 1 shows a functional block diagram of a representative plug-through controller. The controller connects to a standard mains electricity outlet (1) by means of a standard mains electricity plug (2), comprising at least two pins from which 'live' (4) and 'neutral' (3) conducting wires pass through the controller to a second standard mains electricity socket (11), in to which the controlled appliance (12) is plugged. An ammeter (5) placed in series on one or other of the conducting wires, and a Voltmeter (6) is connected across to them. Their measurements are reported to a microprocessor (8) running software which uses them to calculate the power being drawn by the appliance. The microprocessor may report the measurement by means of a communication link (9) to a separate processing unit, which has knowledge of the occupancy state of the controller's location and may respond by sending commands to turn the attached appliance on or off using a relay (10). Alternatively that decision may be taken by the microprocessor (9), if it receives occupancy indications by means of the communications link (9) from an occupancy sensor or intrusion alarm system. The microprocessor also monitors a button (7) or similar human interface, and can switch on or off power to the controlled device according to its input.

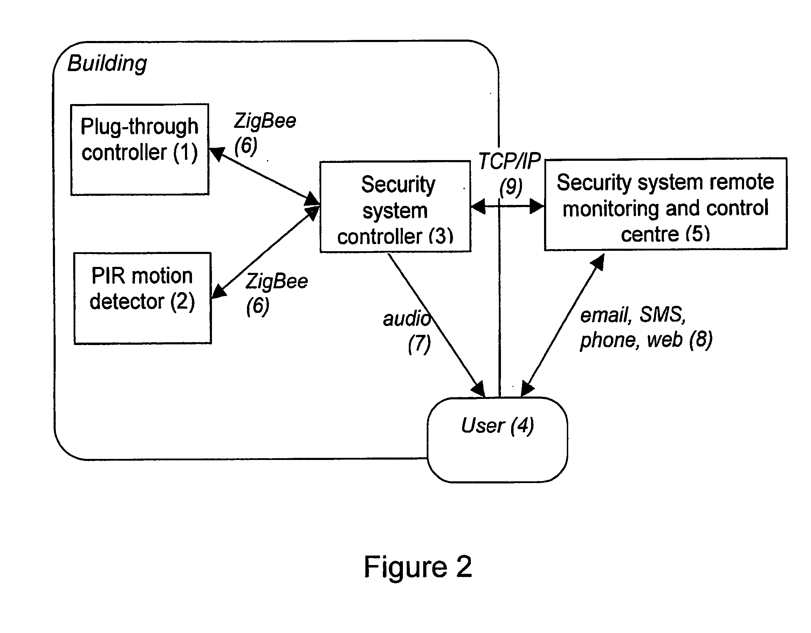

Figure 2 shows an implementation integrating the plug-through controller (1) with an intrusion alarm system, according to the invention. The intrusion alarm system comprises a PIR motion sensor (2), a security system controller (3) and a security system remote monitoring centre (5). The plug-through controller (1) sends power information to and receives switching commands from the security system controller (3) by means of a low-power radio protocol, ZigBee® (6). The PIR motion sensor acts as a presence detector and sends presence information to the security system controller (3), also using ZigBee ® (6). The security system controller (3) uses presence information and rules configured by the user (4) to control the plug-through controller (1). The user sets the configuration using a web interface presented by the security system remote monitoring centre (5), which is in communication with the security system controller (3) by internet communication protocols (9) over cellular, broadband or other connections and sends updated configuration data when necessary. The security system remote monitoring centre (5) also receives data logs and alarm signals from the security system controller (3), communicating these to the user via a user-configured combination (8) of web interface, email, interactive voice-response telephone call, and cellular short message service. These alarm signals indicate exceptional conditions or hazards, such as intruder detection, fire, flood, unlocked doors, unattended cooking appliances and so on, and are additionally notified to the user by the security system controller (3) using an audio output means.

The user configuration described comprises a set of rules, each of which indicates an action to take when a certain set of conditions exist. These conditions comprise any combination of inputs available to the system, including sensor statuses, ZigBee ® network status, elapsed time, actual time, armed or disarmed state, presence indications, daytime/night time, and the contents of event logs. Possible actions include sending an alarm signal to the security system remote monitoring centre (5), outputting an audio signal such as a spoken message, signalling using indicator lamps, and transitioning between states in state machines. These state machines are executed in computer logic in the security system controller (3).To improve usability, most rules are preconfigured and only a few important parameters, such as sensor locations, are left for the user to provide directly via the web interface.

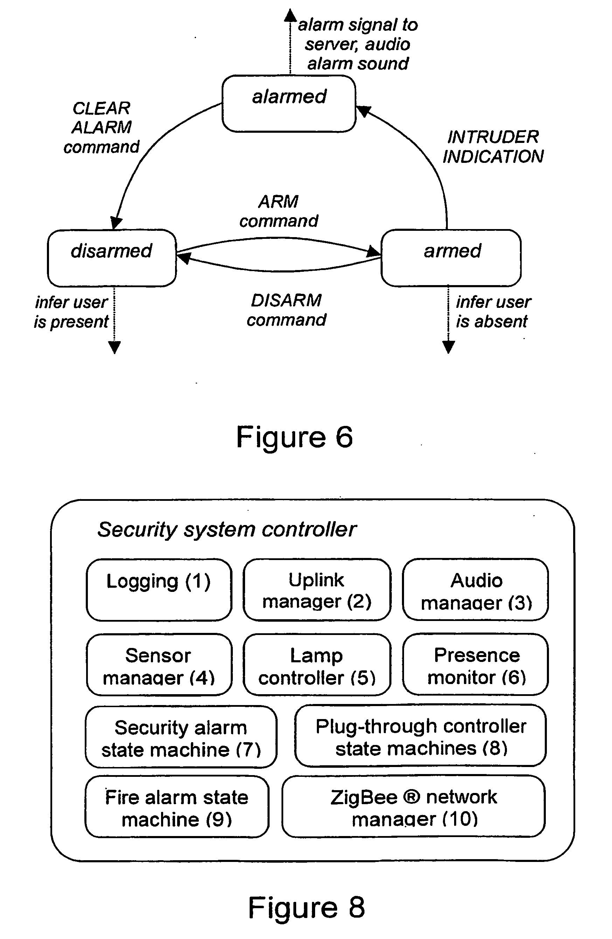

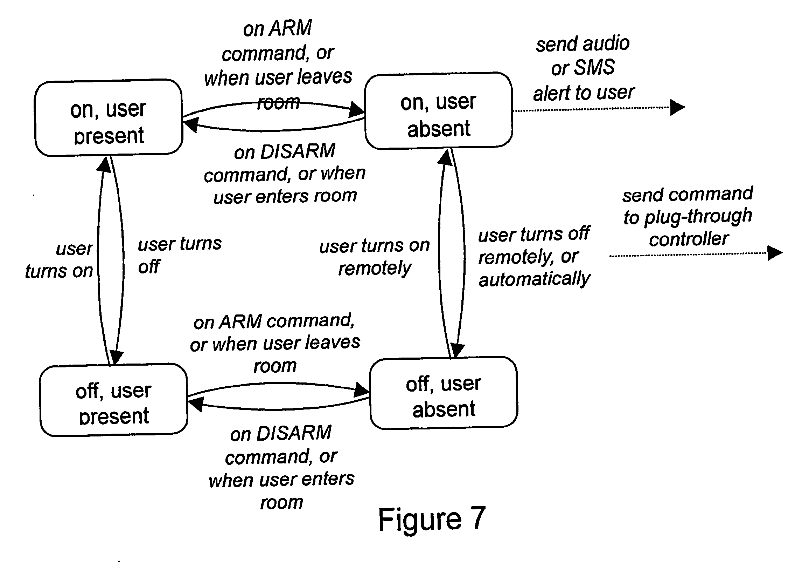

Figure 8 shows schematically the functional elements of the security system controller of Figure 2 (Figure 2 item 3). Logs (1) of data from sensors and local state are maintained and uploaded to the security system remote monitoring centre (Figure 2 item 5) periodically and on demand. An uplink manager (2) monitors the status of the internet connection and if necessary routes communications via GPRS cellular connection. An audio manager (3) prioritises and plays audio outputs and manages the library of audio files. A sensor manager module (4) maintains internal representations of the state of all the system's battery-powered sensors, including presence detectors, so that their state can be queried expeditiously while they are powered down in sleep cycles to conserve energy. A lamp controller (5) manages indicator lamps to show system state or information sent by the remote monitoring centre. A presence monitor module maintains an internal representation of the location of plug-through controllers and presence detectors and the occupancy state thereof. A security alarm state machine (7) runs the core security functions of the system (also see Figure 6). Plug-through controller state machines (8) monitor and respond appropriately to the power and occupancy conditions obtaining at each plug-through controller (also see Figure 7). A fire alarm state machine (9) runs the core fire safety function of the system. A ZigBee® network manager module monitors and maintains the ZigBee ® low-power radiocommunications network.

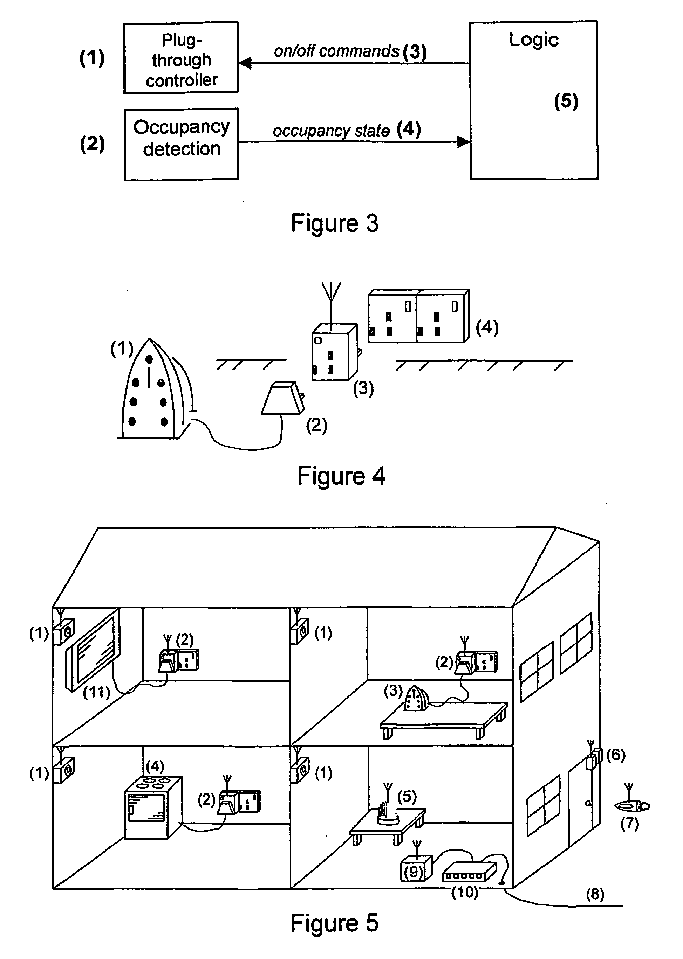

Figure 3 shows the main elements of embodiments of the invention. A plug-through controller (1) is placed in communication with processing logic (5). An occupancy detection means (2) capable of monitoring the location of the appliance controlled by the plug-through controller (1) is also placed in communication with the processing logic (5), such that the occupancy state information is passed (4) to the processing logic. The logic uses this information to decide whether to send commands (3) to the plug-through controller instructing it to turn off or turn on its attached appliance.

The power state of the appliance attached to the plug-through may additionally be reported to the processing logic. Power state in this sense may mean the wattage, voltage, current, on/off /standby state or any combination of those readings.

Figure 4 shows, in exploded form, how a plug-through controller (3) is interposed between a standard three-pin mains electricity socket (4) and an iron (1) or other hazardous electrical appliance. Mechanical and electrical coupling is by means of standard three-pin plugs (2) and sockets (4).

Figure 5 shows this same arrangement (2) in use with an iron (3) and other electrical appliances, including a television (11) and an oven (4), in a domestic setting. Also depicted are PIR motion sensors (1) employed as presence detectors in each room, a magnetic contact sensor (6) used to detect opening of the front door, a key fob (7) by operation of which users may arm or disarm the security system, and an indicator lamp (5) placed in an easily observable position where it can be used to indicate, using colours and blink patterns, conditions such as hazardous unattended appliances. A security system controller (9) (see Figure 8 and Figure 2 item 3) is connected by Ethernet to a network router / broadband modem (10), which provides a connection (8) to the internet and hence to the security system remote monitoring centre (Figure 2 item 5).

No doubt many other effective alternatives will occur to the skilled person. For example although embodiments of plug-through controllers including power state monitoring have been described it will be appreciated that in variants of the system the system controller may be employed to remotely control an appliance to switch on and off, for example in response to the detected presence or absence of a person in the room or on the premises.

It will be understood that the invention is not limited to the described embodiments and encompasses modifications apparent to those skilled in the art lying within the scope of the claims appended hereto.

## Claims

1. An intruder alarm system including a monitoring system for monitoring one or more mains-powered electrical appliances, the monitoring system comprising:
at least one plug-through device for monitoring a power state of an electrical appliance;
at least one occupancy detection device (2) to detect human presence in a location of said electrical appliance; and
a system controller (3) coupled to said plug-through device and to said occupancy A detection device (2) and configured to provide a monitoring signal responsive to a determined combination of a said power state of said electrical appliance and absence of human presence in said location of said electrical appliance, wherein said power state conprises a standby power state of said appliance,
wherein the monitoring system is for automatically switching off a said appliance, wherein said plug-through device comprises a plug-through controller (1) including a switch to switch off mains power to said appliance, and wherein said system controller (3) is configured to use said monitoring signal to control switching off of said appliance by said plug-through controller (1), **characterised in that**
the intruder alarm system is configured to provide a user alert when said user arms the intruder alarm system if said monitoring signal indicates said determined combination of said power state and said absence of human presence.

2. An intruder alarm system as claimed in claim 1, wherein said occupancy detection device (2) forms part of said intruder alarm system, and wherein the intruder alarm system is configured to infer said human presence in said location of said electrical appliance from an armed state of said intruder alarm system.

3. An intruder alarm system as claimed in claim 2 wherein said system controller (3) is further configured to perform an action in response to the intruder alarm system inferring from said armed state that a user is absent, wherein said action comprises one or both of automatically turning off a subset said plug-through devices and alerting the user that any of a subset of plug-through devices is connected to a said electrical appliance which is being left operate unattended.

4. An intruder alarm system as claimed in any preceding claim wherein said intruder alarm system is configured to apply one or more rules to identify said determined combination of said power state and said absence of human presence, said rules including one or more of a rule dependent on a power state of said appliance being greater or less than a threshold, a rule dependent on an elapsed time since human presence was last detected in said location, a rule dependent on a light level detected by said system, and a time-of-day, week, month or year-dependent rule.

5. An intruder alarm system as claimed in claim 4 wherein a said rule comprises a rule to inhibit a user alert or switching off of said appliance.

6. An intruder alarm system as claimed in any preceding claim configured to alert a user of said system to said electrical appliance being left in an on state.

7. An intruder alarm system as claimed in claim 6 including an interface to a mobile communications network, and configured to provide said alert using a short message service of said mobile communications network.

8. An intruder alarm system as claimed in any preceding claim comprising a plurality of said plug-through devices, and wherein said system controller (3) is configured to implement a state machine for each said plug-through device to monitor a state of the device.

9. An intruder alarm system as claimed in any preceding claim wherein said system controller (3) has a connection to a remote server (5), to receive configuration data from said server (5) for configuring said determined combination of said power state and said absence of human presence, and to provide data derived from said monitoring signal to said remote server (5) to enable said remote server (5) to alert a user.

10. An intruder alarm system as claimed in any preceding claim wherein said at least one occupancy detection device (2) and said system controller (3) are physically located in said plug-through device.

11. A security system conprising an intruder alarm system as claimed in claim 9 and said remote server (5), wherein said remote server (5) is configured to provide an Internet-accessible user interface for configuring the system.

12. A carrier carrying computer program code to, when running, implement the intruder alarm system of any preceding claim.

## Patentansprüche

1. Einbruchalarmsystem einschließlich eines Überwachungssystems zum Überwachen von einem oder mehreren netzversorgten Elektrogeräten, wobei das Überwachungssystem Folgendes umfasst:
mindestens eine Zwischensteckereinrichtung zum Überwachen eines Leistungsstatus eines Elektrogeräts;
mindestens eine Belegungserkennungseinrichtung (2) zum Erkennen von menschlicher Anwesenheit an einem Standort des Elektrogeräts; und
einen Systemregler (3), der an die Zwischensteckereinrichtung und die Belegungserkennungseinrichtung (2) gekoppelt ist und dazu konfiguriert ist, ein Überwachungssignal bereitzustellen, das auf eine ermittelte Kombination eines solchen Leistungsstatus des Elektrogeräts und der fehlenden menschlichen Anwesenheit am Standort des Elektrogeräts reagiert, worin der Leistungsstatus einen Standby-Leistungsstatus des Geräts umfasst,
worin das Überwachungssystem dem automatischen Ausschalten eines solchen Geräts dient, worin die Zwischensteckereinrichtung einen Zwischensteckerregler (1) umfasst einschließlich eines Schalters zum Ausschalten der Netzversorgung zum Gerät, und worin der Systemregler (3) dazu konfiguriert ist, das Überwachungssignal zu verwenden, um das Ausschalten des Geräts durch den Zwischensteckerregler (1) zu regeln, **dadurch gekennzeichnet, dass**
das Einbruchalarmsystem dazu konfiguriert ist, eine Benutzerwarnung bereitzustellen, wenn der Benutzer das Einbruchalarmsystem scharfschaltet, falls das Überwachungssignal die ermittelte Kombination des Leistungsstatus und der fehlenden menschlichen Anwesenheit anzeigt.

2. Einbruchalarmsystem nach Anspruch 1, worin die Belegungserkennungseinrichtung (2) einen Teil des Einbruchalarmsystems bildet und worin das Einbruchalarmsystem dazu konfiguriert ist, die menschliche Anwesenheit am Standort des Elektrogeräts aus einem scharfgeschalteten Status des Einbruchalarmsystems zu schließen.

3. Einbruchalarmsystem nach Anspruch 2, worin der Systemregler (3) außerdem dazu konfiguriert ist, eine Aktion als Reaktion darauf auszuführen, dass das Einbruchalarmsystem aus dem scharfgeschalteten Status folgert, dass ein Benutzer abwesend ist, worin die Aktion eins oder beide von Folgenden umfasst: eine Teilmenge der Zwischensteckereinrichtungen automatisch auszuschalten und den Benutzer zu warnen, dass eine einer Teilmenge von Zwischensteckereinrichtungen an ein solches Elektrogerät angeschlossen ist, dessen Betrieb unbeaufsichtigt gelassen wird.

4. Einbruchalarmsystem nach einem vorhergehenden Anspruch, worin das Einbruchalarmsystem dazu konfiguriert ist, eine oder mehrere Regeln anzuwenden, um die ermittelte Kombination des Leistungsstatus und der fehlenden menschlichen Anwesenheit zu identifizieren, wobei die Regeln eine oder mehrere von Folgenden enthalten: eine Regel, die davon abhängt, dass ein Leistungsstatus des Geräts größer oder kleiner als eine Schwellenwert ist, eine Regel, die von einer abgelaufenen Zeit abhängt, seit menschliche Anwesenheit am Standort zuletzt erkannt wurde, eine Regel, die von einem vom System erkannten Lichtniveau abhängt und eine von Tageszeit, Woche, Monat oder Jahr abhängige Regel.

5. Einbruchalarmsystem nach Anspruch 4, worin eine solche Regel eine Regel umfasst, eine Benutzerwarnung oder das Ausschalten des Geräts zu inhibieren.

6. Einbruchalarmsystem nach einem vorhergehenden Anspruch, das dazu konfiguriert ist, einen Benutzer des Systems zu warnen, dass das Elektrogerät in einem eingeschaltetem Status gelassen wird.

7. Einbruchalarmsystem nach Anspruch 6, eine Schnittstelle zu einem Mobilkommunikationsnetz enthaltend und dazu konfiguriert, die Warnung unter Verwendung eines Short-Message-Dienstes des Mobilkommunikationssystems bereitzustellen.

8. Einbruchalarmsystem nach einem vorhergehenden Anspruch, eine Vielzahl von Zwischensteckereinrichtungen umfassend, und worin der Systemregler (3) dazu konfiguriert ist, eine Statusmaschine für jede Zwischensteckereinrichtung zu implementieren, um einen Status der Einrichtung zu überwachen.

9. Einbruchalarmsystem nach einem vorhergehenden Anspruch, worin der Systemregler (3) eine Verbindung zu einem entfernten Server (5) hat, um Konfigurationsdaten vom Server (5) zum Konfigurieren der ermittelten Kombination des Leistungsstatus und der fehlenden menschlichen Anwesenheit zu empfangen und dem entfernten Server (5) vom Überwachungssignal abgeleitete Daten bereitzustellen, um den entfernten Server (5) zu aktivieren, einen Benutzer zu warnen.

10. Einbruchalarmsystem nach einem vorhergehenden Anspruch, worin die mindestens eine Belegungserkennungseinrichtung (2) und der Systemregler (3) in der Zwischensteckereinrichtung physikalisch positioniert sind.

11. Sicherheitssystem, ein Einbruchalarmsystem nach Anspruch 9 und den entfernten Server (5) umfassend, worin der entfernte Server (5) dazu konfiguriert ist, eine intemetzugreifbare Benutzerschnittstelle zum Konfigurieren des Systems bereitzustellen.

12. Träger, der Computerprogrammcode trägt, um beim Ablaufen das Einbruchalarmsystem nach einem vorhergehenden Anspruch zu implementieren.

## Revendications

1. Système de détection d'intrusion comprenant un système de surveillance pour surveiller un ou plusieurs appareils électriques alimentés par secteur, le système de surveillance comprenant :
au moins un dispositif branché pour surveiller un état d'alimentation d'un appareil électrique ;
au moins un dispositif de détection d'occupation (2) pour détecter une présence humaine à un emplacement dudit appareil électrique ; et
un contrôleur de système (3) couplé audit dispositif branché et audit dispositif de détection d'occupation (2) et configuré pour fournir un signal de surveillance en réponse à une combinaison déterminée d'un dit état d'alimentation dudit appareil électrique et d'une absence de présence humaine audit emplacement dudit appareil électrique, dans lequel ledit état d'alimentation comprend un état d'alimentation au repos dudit appareil,
dans lequel le système de surveillance sert à arrêter automatiquement un dit appareil, dans lequel ledit dispositif branché comprend un contrôleur branché (1) comprenant un commutateur pour arrêter l'alimentation secteur dudit appareil, et dans lequel ledit contrôleur de système (3) est configuré pour utiliser ledit signal de surveillance pour commander l'arrêt dudit appareil par ledit contrôleur branché (1), **caractérisé en ce que**
le système de détection d'intrusion est configuré pour alerter un utilisateur lorsque ledit utilisateur met en service le système de détection d'intrusion si ledit signal de surveillance indique ladite combinaison déterminée dudit état d'alimentation et de ladite absence de présence humaine.

2. Système de détection d'intrusion selon la revendication 1, dans lequel ledit dispositif de détection d'occupation (2) forme une partie dudit système de détection d'intrusion, et dans lequel le système de détection d'intrusion est configuré pour déduire ladite présence humaine audit emplacement dudit appareil électrique à partir d'un état de mise en service dudit système de détection d'intrusion.

3. Système de détection d'intrusion selon la revendication 2, dans lequel ledit contrôleur de système (3) est en outre configuré pour effectuer une action en réponse à la déduction, par le système de détection d'intrusion, à partir dudit état de mise en service, qu'un utilisateur est absent, dans lequel ladite action comprend l'un, ou les deux, de l'arrêt automatique d'un sous-ensemble desdits dispositifs branchés et de l'alerte de l'utilisateur du fait que l'un quelconque d'un sous-ensemble de dispositifs branchés est connecté à un dit appareil électrique qui est laissé en marche sans surveillance.

4. Système de détection d'intrusion selon l'une quelconque des revendications précédentes, dans lequel ledit système de détection d'intrusion est configuré pour appliquer une ou plusieurs règles pour identifier ladite combinaison déterminée dudit état d'alimentation et de ladite absence de présence humaine, lesdites règles comprenant une ou plusieurs d'une règle dépendant d'un état d'alimentation dudit appareil qui est supérieur ou inférieur à un seuil, d'une règle dépendant d'un temps écoulé depuis la dernière détection d'une présence humaine audit emplacement, d'une règle dépendant d'un niveau de lumière détecté par ledit système, et d'une règle dépendant d'un créneau horaire, d'une semaine, d'un mois ou d'une année.

5. Système de détection d'intrusion selon la revendication 4, dans lequel une dite règle comprend une règle pour interdire une alerte d'utilisateur ou un arrêt dudit appareil.

6. Système de détection d'intrusion selon l'une quelconque des revendications précédentes, configuré pour alerter un utilisateur dudit système du fait que ledit appareil électrique est laissé dans un état de marche.

7. Système de détection d'intrusion selon la revendication 6, comprenant une interface vers un réseau de communication mobile, et configuré pour fournir ladite alerte en utilisant un service de messages courts dudit réseau de communication mobile.

8. Système de détection d'intrusion selon l'une quelconque des revendications précédentes, comprenant une pluralité desdits dispositifs branchés, et dans lequel ledit contrôleur de système (3) est configuré pour mettre en oeuvre une machine à états pour chaque dit dispositif branché pour surveiller un état du dispositif.

9. Système de détection d'intrusion selon l'une quelconque des revendications précédentes, dans lequel ledit contrôleur de système (3) à une connexion à un serveur à distance (5), pour recevoir des données de configuration dudit serveur (5) pour configurer ladite combinaison déterminée dudit état d'alimentation et de ladite absence de présence humaine, et pour fournir des données déduites dudit signal de surveillance audit serveur à distance (5) pour permettre audit serveur à distance (5) d'alerter un utilisateur.

10. Système de détection d'intrusion selon l'une quelconque des revendications précédentes, dans lequel ledit au moins un dispositif de détection d'occupation (2) et ledit contrôleur de système (3) sont situés physiquement dans ledit dispositif branché.

11. Système de sécurité comprenant un système de détection d'intrusion selon la revendication 9 et ledit serveur à distance (5), dans lequel ledit serveur à distance (5) est configuré pour fournir une interface utilisateur accessible par Internet pour configurer le système.

12. Support supportant un code de programme d'ordinateur, pour, lorsqu'il est exécuté, mettre en oeuvre le système de détection d'intrusion de l'une quelconque des revendications précédentes.
